(19) Europäisches Patentamt
European Patent Office
Office européen des brevets

(11) **EP 4 770 297 A1**

(12) **EUROPEAN PATENT APPLICATION**

(43) Date of publication:
01.07.2026 Bulletin 2026/27

(21) Application number: 25226830.5

(22) Date of filing: 23.12.2025

(51) International Patent Classification (IPC):
*H05K 7/20* (2006.01)    *F28F 27/00* (2006.01)
*G05B 23/02* (2006.01)    *F24F 11/64* (2018.01)

(52) Cooperative Patent Classification (CPC):
**F24F 11/64; G05B 23/0235; H05K 7/20836;**
G05B 2219/2614

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 27.12.2024  US 202463739449 P
17.12.2025  US 202519423795

(71) Applicant: **Vertiv International GmbH
8212 Neuhausen am Rheinfall (CH)**

(72) Inventors:
• **TAKACS, Balint
8212 Schaffhausen (CH)**
• **BARBATO, Pierpaolo
8212 Schaffhausen (CH)**
• **PEREJDA, Jan
8212 Schaffhausen (CH)**
• **BISSARO, Carlo
8212 Schaffhausen (CH)**

(74) Representative: **Ambroz, Simon et al
Kilburn & Strode LLP
Lacon London
84 Theobalds Road
London WC1X 8NL (GB)**

(54) **HEAT EXCHANGER CLOG DETECTION**

(57)    A method for detecting heat exchanger clogging in a cooling system can include determining expected operational parameters, detecting current operational parameters, confirming that the cooling system is operating in steady state as a prerequisite to detecting the current operational parameters, comparing the expected operational parameters with the current operational parameters, identifying heat exchanger clogging based at least in part on the comparison, and providing an indication if heat exchanger clogging is detected. Determining expected operational parameters can include operating the cooling system in steady state and/or at predetermined capacity and recording then current operational parameters as the expected operational parameters and/or calculating the expected operational parameters.

FIG. 1

## Description

CROSS-REFERENCE TO RELATED APPLICATION(S)

This application claims the benefit of U.S. Provisional Patent Application No. 63/739,449 filed December 27, 2024, and US Nonprovisional Patent Application No. 19/423,795 filed December 17, 2025.

TECHNICAL FIELD

The present disclosure relates generally to cooling systems and more specifically relates to monitoring data center cooling systems.

BACKGROUND

Data center operators generally want their systems, including their cooling systems, to operate as efficiently as possible, while still meeting demands. If heat exchangers become clogged, cooling system efficiency decreases.

More specifically, dust, dirt, and other contaminants are often entrained in air passing through fluid-to-air heat exchangers, especially exterior condensers. Contaminants can build up, clogging an airflow path through a heat exchanger and/or insulating a heat exchanger from air flowing therethrough. Reduced airflow and/or such insulation can decrease heat transfer, decreasing efficiency. Fluid-to-fluid heat exchangers can experience similar issues.

SUMMARY

Applicant has created new and useful devices, systems and methods for detecting clogging in heat exchangers, such as those for use in data center cooling systems. In at least one example, systems for detecting heat exchanger clogging in a cooling system according to the disclosure can automatically detect when a flow path, such as an airflow path and/or a fluid flow path is clogged, or flow is reduced therethrough, which can decrease efficiency of the cooling system. In at least one example, systems according to the disclosure can provide messages indicating a potentially clogged path and/or a low confidence of heat exchanger clogging, warnings indicating a path experiencing limited clogging and/or a medium confidence of heat exchanger clogging, alarms indicated a significantly clogged path and/or a high confidence of heat exchanger clogging, or any combination thereof.

In at least one example, a method for detecting heat exchanger clogging in a cooling system according to the disclosure can include determining expected operational parameters, detecting current operational parameters, confirming that the cooling system is operating in steady state as a prerequisite to detecting the current operational parameters, comparing the expected operational parameters with the current operational parameters, identifying heat exchanger clogging based at least in part on the comparison, providing an indication if heat exchanger clogging is detected, or any combination thereof. In at least one example, determining expected operational parameters can include operating the cooling system in steady state and/or at predetermined capacity and recording then current operational parameters as the expected operational parameters and/or calculating the expected operational parameters. In at least one example, comparing the expected operational parameters with the current operational parameters can include calculating a difference between the expected operational parameters and the current operational parameters.

In at least one example, calculating the expected operational parameters can be based on one or more speeds, such as one or more fan speeds, one or more pump speeds, or any combination thereof. In at least one example, calculating the expected operational parameters can be based on one or more flow rates. In at least one example, calculating the expected operational parameters can be based on one or more pressures, such as one or more suction pressures, one or more discharge pressures, one or more condensing pressures, one or more differential pressures (such as across a heat exchanger and/or a filter), or any combination thereof. In at least one example, calculating the expected operational parameters can be based on one or more temperatures, such as one or more cooling medium temperatures, one or more refrigerant temperatures, one or more air temperatures, or any combination thereof. In at least one example, calculating the expected operational parameters can be based on one or more demand signals. In at least one example, calculating the expected operational parameters can be based on one or more capacities, such as one or more pump capacities, one or more compressor capacities, one or more plumbing capacities, one or more cooling capacities (such as of one or more cooling loops, circuits, or units), or any combination thereof.

In at least one example, calculating the expected operational parameters can include calculating one or more speeds, such as one or more fan speeds, one or more pump speeds, or any combination thereof. In at least one example, calculating the expected operational parameters can include calculating one or more flow rates. In at least one example, calculating the expected operational parameters can include calculating one or more pressures, such as one or more suction pressures, one or more discharge pressures, one or more condensing pressures, one or more differential pressures (such as across a heat exchanger and/or a filter), or any combination thereof. In at least one example, calculating the expected operational parameters can include calculating one or more temperatures, such as one or more cooling medium temperatures, one or more refrigerant temperatures, one or more air temperatures, or any combination thereof.

In at least one example, providing an indication if heat exchanger clogging is detected can include providing a warning, an alarm, or other message if clogging is detected. In at least one example, providing an indication if heat exchanger clogging is detected can include providing a message if the difference (between current and expected operational parameters) exceeds a first threshold. In at least one example, providing an indication if heat exchanger clogging is detected can include providing a warning if the difference exceeds a second threshold. In at least one example, providing an indication if heat exchanger clogging is detected can include providing an alarm if the difference exceeds a third threshold. In at least one example, the second threshold can be greater than the first threshold. In at least one example, the third threshold can be greater than the first threshold and/or the second threshold.

In at least one example, a method for detecting heat exchanger clogging in a cooling system having a plurality of cooling units according to the disclosure can include operating a first cooling unit of the cooling system at a predetermined capacity, detecting a first set of current operational parameters of the first cooling unit, recording the first set of current operational parameters of the first cooling unit as expected operational parameters, determining a current capacity of the cooling system, calculating a maximum capacity of the cooling system without the first cooling unit, waiting a predetermined period of time, performing a checking procedure if the maximum capacity is greater than the current capacity, or any combination thereof. In at least one example, the checking procedure can include operating the first cooling unit at the predetermined capacity while providing the current capacity with the cooling system (as a whole), detecting a second set of current operational parameters of the first cooling unit, comparing the expected operational parameters with the second set of current operational parameters, identifying heat exchanger clogging based at least in part on the comparison, or any combination thereof.

In at least one example, the current capacity can vary, such as according to a demand and/or a demand signal. In at least one example, the current capacity, as used herein, need not be a measure of maximum capability. In at least one example, the current capacity, as used herein, can be a measure of a current cooling output of the cooling system, which can vary according to the demand and/or the demand signal. In at least one example, as the demand and/or the demand signal changes, the current capacity of the cooling system can change to meet that demand and/or demand signal. In at least one example, as the demand and/or the demand signal changes, the current capacity of the cooling system can change proportionally.

In at least one example, operating the first cooling unit at the predetermined capacity while providing the current capacity with the cooling system can include operating the first cooling unit in steady state at the predetermined capacity and varying a second capacity of a second cooling unit of the cooling system in proportion to the demand and/or the demand signal. In at least one example, operating the first cooling unit at the predetermined capacity while providing the current capacity with the cooling system can include operating the first cooling unit in steady state at the predetermined capacity and varying one or more other cooling units of the cooling system in proportion to the demand and/or the demand signal, such as one or more speeds, one or more flow rates, one or more outputs, one or more capacities, or any combination thereof of one or more other cooling units.

In at least one example, the checking procedure can be performed periodically, such as daily, weekly, monthly, or any combination thereof. In at least one example, the checking procedure can be performed periodically if the maximum capacity is greater than the current capacity. In at least one example, the checking procedure can be performed periodically if, and only if, the maximum capacity is greater than the current capacity. In at least one example, the checking procedure can be performed after a period of time has expired. In at least one example, the checking procedure can be performed when the maximum capacity is greater than the current capacity after a period of time has expired. In at least one example, the checking procedure can be performed after a period of time has expired and the current capacity drops below the maximum capacity.

In at least one example, the maximum capacity, as used herein, need not be the maximum capacity of the entire cooling system. In at least one example, the maximum capacity, as used herein, can be the maximum capacity of the cooling system without one or more cooling units of the cooling system.

In at least one example, a method for detecting heat exchanger clogging according to the disclosure can include utilizing two or more detection techniques. In at least one example, a method for detecting heat exchanger clogging according to the disclosure can include operating a cooling system in steady state and recording a first set of current operational parameters of the cooling system as a first set of expected operational parameters, determining a current capacity of the cooling system, calculating a second set of expected operational parameters based at least in part on the current capacity, detecting a second set of current operational parameters of the cooling system, comparing the second set of current operational parameters with the first set of expected operational parameters and the second set of expected operational parameters, identifying heat exchanger clogging based at least in part on the comparison, or any combination thereof. In at least one example, the first set of expected operational parameters can include an indication of a first capacity at which the first set of current operational parameters was recorded. In at least one example, the method can include creating a first extrapolated set of expected operational parameters, such as by extrapolating the first set of expected operational parameters based at least in part on a difference between the current capacity and the first capacity. In at least one example, comparing the second set of current operational parameters with the first set of expected operational parameters can be or include comparing the second set of current operational parameters with the first extrapolated set of expected operational parameters. In at least one example, each set of current and/or expected operational parameters can include one or more expected operational parameters, such as one or more speeds, one or more flow rates, one or more pressures, one or more temperatures, one or more capacities, or any combination thereof.

In at least one example, identifying heat exchanger clogging based at least in part on the comparison can include determining that the second set of current operational parameters exceeds one or more of the expected operational parameters. In at least one example, identifying heat exchanger clogging based at least in part on the comparison can include determining that the second set of current operational parameters exceeds the first extrapolated set of expected operational parameters by a first threshold, determining that the second set of current operational parameters exceeds the second set of expected operational parameters by a second threshold, determining that the second set of current operational parameters exceeds the first extrapolated set of expected operational parameters by the first threshold and/or that the second set of current operational parameters exceeds the second set of expected operational parameters by the second threshold, or any combination thereof. In at least one example, the first threshold can be the same as, or different from, the second threshold.

In at least one example, identifying heat exchanger clogging based at least in part on the comparison can include determining that the second set of current operational parameters exceeds one or more of the sets of expected operational parameters by one or more thresholds. In at least one example, identifying heat exchanger clogging based at least in part on the comparison can include determining that the second set of current operational parameters exceeds either of the sets of expected operational parameters by one threshold or multiple sets of expected operational parameters by another threshold. In at least one example, identifying heat exchanger clogging based at least in part on the comparison can include weighting one or more set of expected operational parameters higher than another set of expected operational parameters. In at least one example, the method for detecting heat exchanger clogging according to the disclosure can provide an indication of heat exchanger clogging, in indication of a severity of heat exchanger clogging, an indication of a confidence level of heat exchanger clogging, or any combination thereof.

In at least one example, identifying heat exchanger clogging based at least in part on the comparison can include determining that the second set of current operational parameters exceeds the first extrapolated set of expected operational parameters and the second set of expected operational parameters by a first threshold, that the second set of current operational parameters exceeds the first extrapolated set of expected operational parameters by a second threshold, that the second set of current operational parameters exceeds the second set of expected operational parameters by a third threshold, or any combination thereof. In at least one example, the second threshold can be greater than the first threshold. In at least one example, the third threshold can be greater than the second threshold and/or the first threshold.

In at least one example, the method can include operating a first cooling unit of the cooling system at a predetermined capacity, detecting a third set of current operational parameters of the first cooling unit, recording the third set of current operational parameters of the first cooling unit as a third set of expected operational parameters, calculating a maximum capacity of the cooling system without the first cooling unit, waiting a predetermined period of time, performing a checking procedure if (and only if) the maximum capacity is greater than the current capacity, or any combination thereof. In at least one example, the checking procedure can include operating the first cooling unit at the predetermined capacity while providing the current capacity with the cooling system, detecting a fourth set of current operational parameters of the first cooling unit, or any combination thereof. In at least one example, comparing the current operational parameters with the expected operational parameters can include comparing the third set of expected operational parameters with the fourth set of current operational parameters.

In at least one example, identifying heat exchanger clogging based at least in part on the comparison can include determining that the second set of current operational parameters exceeds the first extrapolated set of expected operational parameters by a first threshold, the second set of current operational parameters exceeds the second set of expected operational parameters by a second threshold, and the fourth set of current operational parameters exceeds the third set of expected operational parameters by a third threshold. In at least one example, identifying heat exchanger clogging based at least in part on the comparison can include determining that the second set of current operational parameters exceeds the first extrapolated set of expected operational parameters by a first threshold and the second set of current operational parameters exceeds the second set of expected operational parameters by a second threshold, that the second set of current operational parameters exceeds the first extrapolated set of expected operational parameters by the first threshold and the fourth set of current operational parameters exceeds the third set of expected operational parameters by a third threshold, that the second set of current operational parameters exceeds the second set of expected operational parameters by the second threshold and the fourth set of current operational parameters exceeds the third set of expected operational parameters by the third threshold, or any combination thereof. In at least one example, the second threshold can be less than, greater than, or the same as the first threshold. In at least one example, the third threshold can be less than, greater than, or the same as the second threshold and/or the first threshold.

BRIEF DESCRIPTION OF THE DRAWINGS

 FIG. 1 is a schematic view of one of many examples of a cooling system according to the disclosure.
 FIG. 2 is a schematic view of another one of many examples of a cooling system according to the disclosure.
 FIG. 3 is a graph of an operating parameter versus a cooling capacity with and without heat exchanger clogging.
 FIG. 4 is a graph of another operating parameter versus a cooling capacity with and without heat exchanger clogging.
 FIG. 5 is a simplified view of one of many examples of a heat exchanger of a cooling system according to the disclosure.
 FIG. 6 is a graph of a pressure versus a flow rate, showing measurements indicating heat exchanger clogging.
 FIG. 7 is a flow chart of one of many examples of a method for detecting heat exchanger clogging according to the disclosure.
 FIG. 8 is a flow chart of another one of many examples of a method for detecting heat exchanger clogging according to the disclosure.
 FIG. 9 is a flow chart of a portion of yet another one of many examples of a method for detecting heat exchanger clogging according to the disclosure.
 FIG. 10 is a flow chart of another portion of the method of FIG. 9.
 FIG. 11 is a simplified flow diagram of one of many examples of a heat exchanger of a cooling system according to the disclosure.
 FIG. 12 is a simplified flow diagram of another one of many examples of a heat exchanger of a cooling system according to the disclosure.

DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial example of the inventions are described or shown for the sake of clarity and understanding. Persons of skill in this art will also appreciate that the development of an actual commercial example incorporating aspects of the present inventions will require numerous implementation-specific decisions to achieve the developer's ultimate goal for the commercial example. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the inventions or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various examples of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for detecting clogging in heat exchangers, such as those for use in data center cooling systems. In at least one example, systems for detecting heat exchanger clogging in a cooling system according to the disclosure can automatically detect when a flow path, such as an airflow path and/or a fluid flow path is clogged, or flow is reduced therethrough, which can decrease efficiency of the cooling system. In at least one example, systems according to the disclosure can provide messages indicating a potentially clogged path and/or a low confidence of heat exchanger clogging, warnings indicating a path experiencing limited clogging and/or a medium confidence of heat exchanger clogging, alarms indicated a significantly clogged path and/or a high confidence of heat exchanger clogging, or any combination thereof.

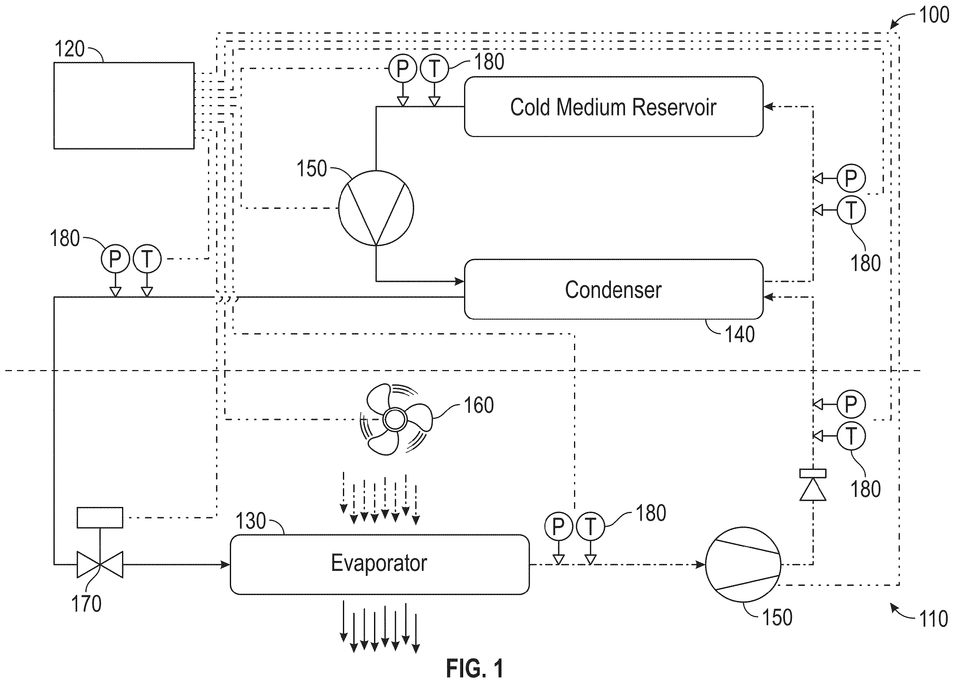

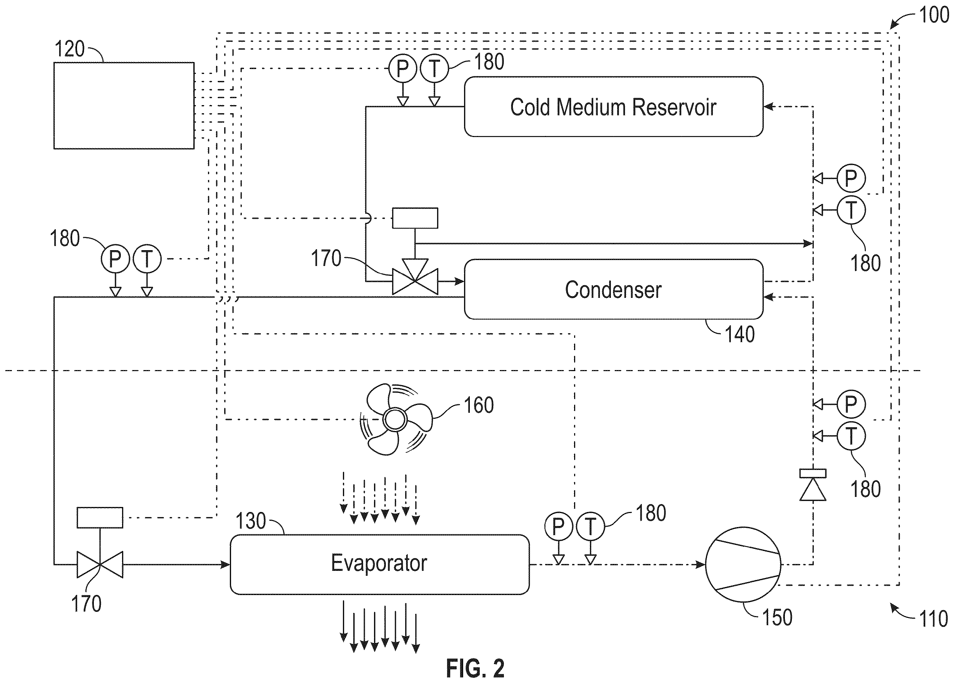

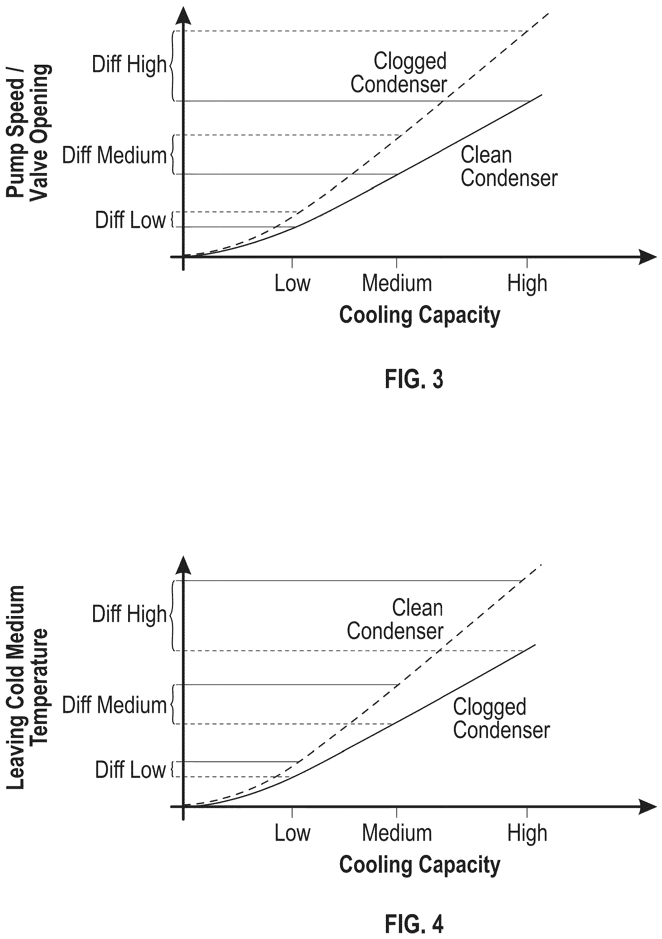

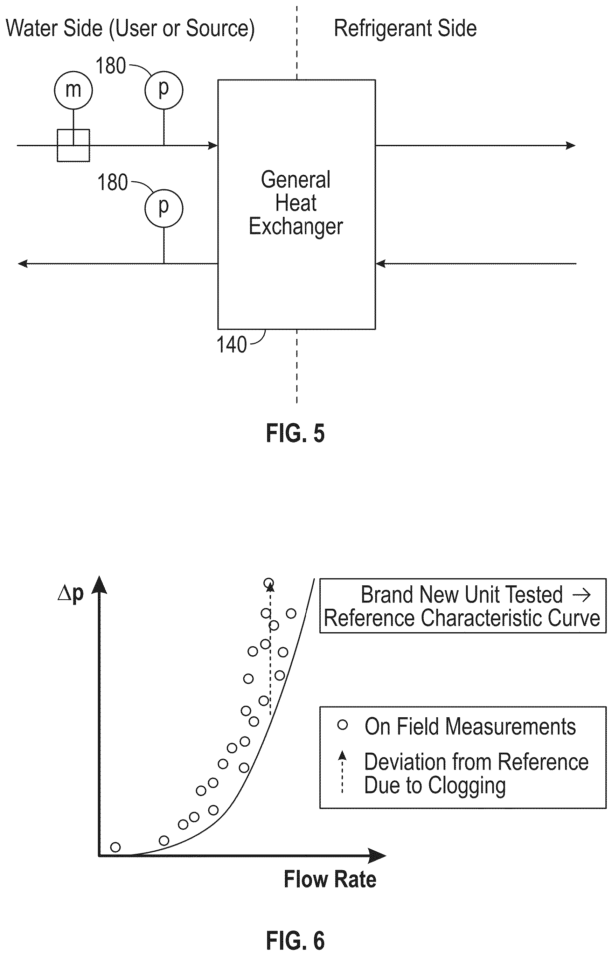

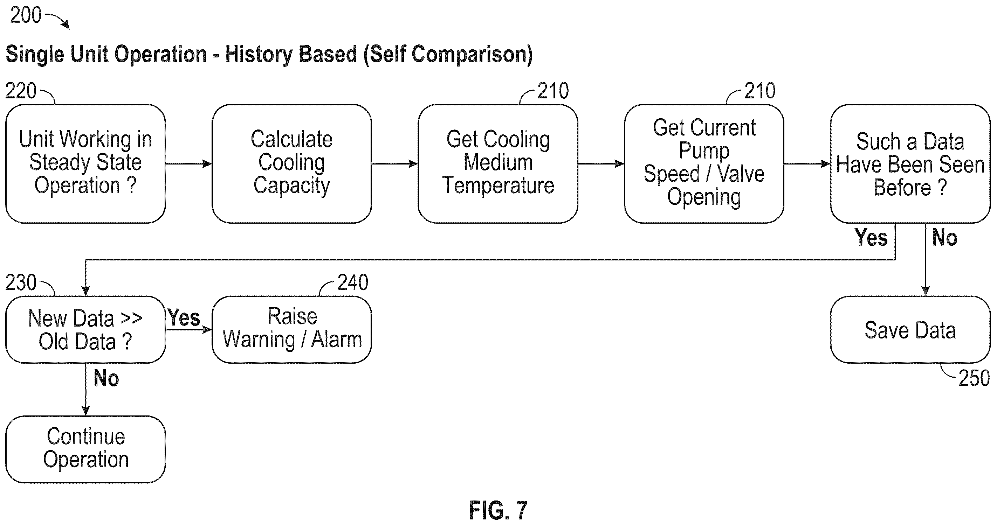

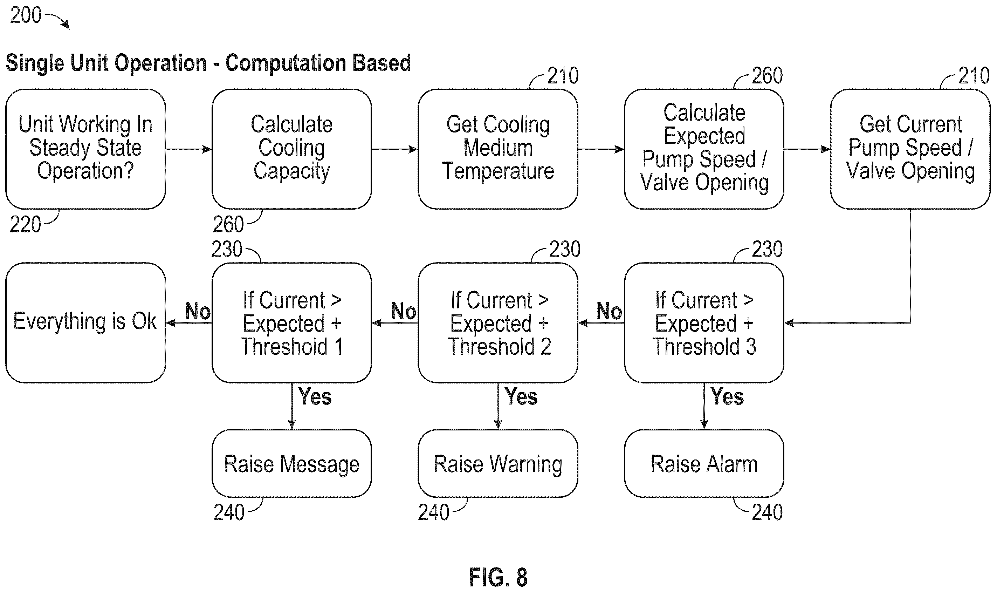

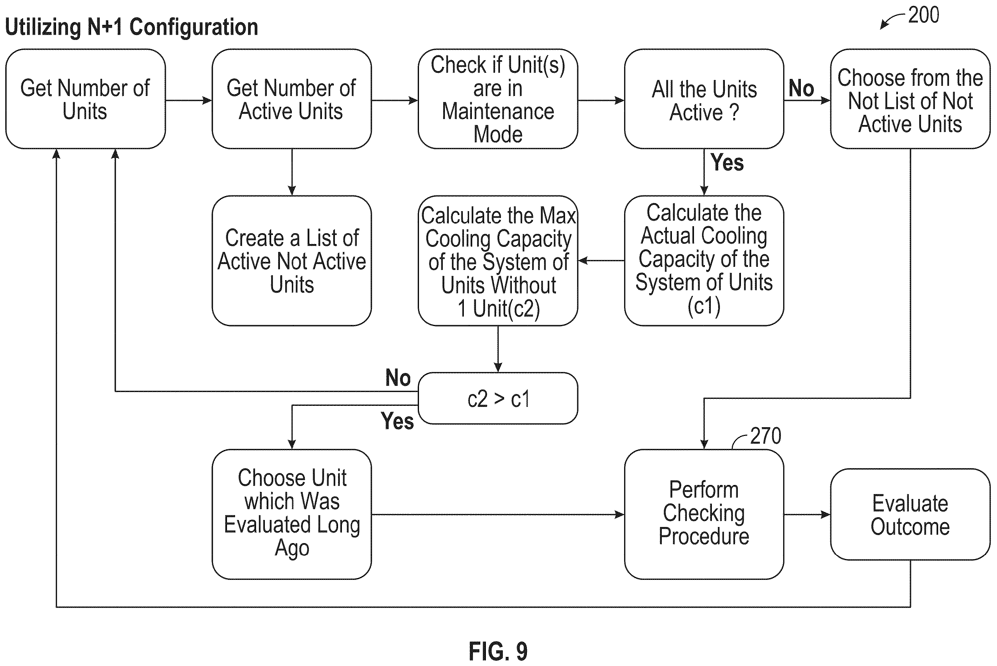

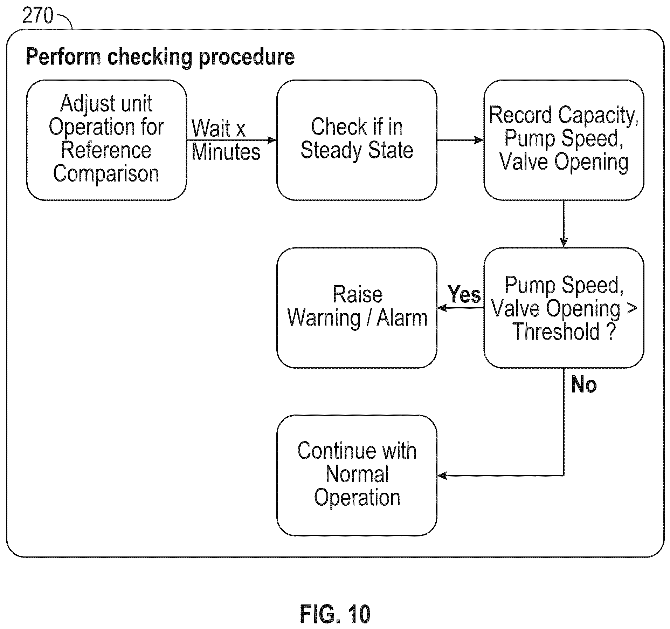

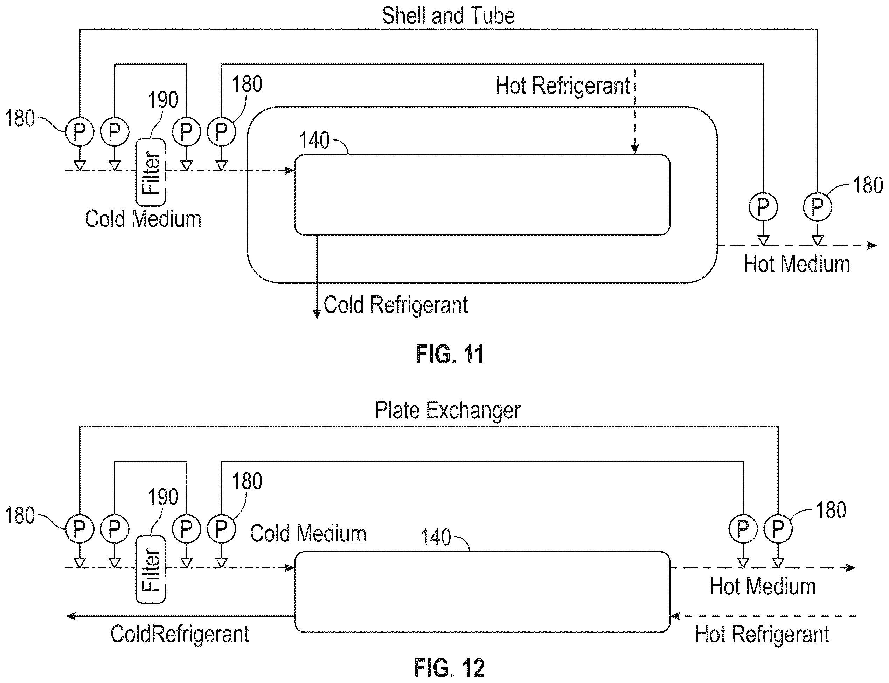

FIG. 1 is a schematic view of one of many examples of a cooling system according to the disclosure. FIG. 2 is a schematic view of another one of many examples of a cooling system according to the disclosure. FIG. 3 is a graph of an operating parameter versus a cooling capacity with and without heat exchanger clogging. FIG. 4 is a graph of another operating parameter versus a cooling capacity with and without heat exchanger clogging. FIG. 5 is a simplified view of one of many examples of a heat exchanger of a cooling system according to the disclosure. FIG. 6 is a graph of a pressure versus a flow rate, showing measurements indicating heat exchanger clogging. FIG. 7 is a flow chart of one of many examples of a method for detecting heat exchanger clogging according to the disclosure. FIG. 8 is a flow chart of another one of many examples of a method for detecting heat exchanger clogging according to the disclosure. FIG. 9 is a flow chart of a portion of yet another one of many examples of a method for detecting heat exchanger clogging according to the disclosure. FIG. 10 is a flow chart of another portion of the method of FIG. 9. FIG. 11 is a simplified flow diagram of one of many examples of a heat exchanger of a cooling system according to the disclosure. FIG. 12 is a simplified flow diagram of another one of many examples of a heat exchanger of a cooling system according to the disclosure. FIGS. 1-12 are described in conjunction with one another.

In at least one example, a cooling system 100 according to the disclosure can include one or more cooling units, circuits, or loops 110 and/or one or more controllers 120 for controlling various components of the cooling system 100 and/or cooling unit(s) 110. In at least one example, any or all of the cooling units 110 can include one or more evaporators 130 for extracting heat, such as from computer equipment in a data center, one or more condensers 140 for rejecting that heat, either to an exterior environment and/or to another cooling medium, one or more compressors or pumps 150 for circulating a refrigerant or other cooling fluid through the evaporator 130 and/or the condenser 140, one or more fans 160 for inducing airflow through the evaporator 130 and/or the condenser 140, or any combination thereof. In at least one example, any or all of the cooling units 110 can include one or more flow control valves 170 for controlling flow of the cooling medium, the refrigerant, the other cooling fluid, or any combination thereof. In at least one example, any or all of the cooling units 110 can include one or more sensors 180 for detecting one or more flow rates, one or more pressures, one or more temperatures, or any combination thereof. In at least one example, any or all of the cooling units 110 can include one or more filters 190 to filter contaminants from the airflow, the cooling medium, the refrigerant, the other cooling fluid, or any combination thereof.

In at least one example, a method 200 for detecting heat exchanger clogging in a cooling system 100 according to the disclosure can include determining expected operational parameters, detecting current operational parameters, as shown in step 210, confirming that the cooling system 100 is operating in steady state as a prerequisite to detecting the current operational parameters, as shown in step 220, comparing the expected operational parameters with the current operational parameters, as shown in step 230, identifying heat exchanger clogging based at least in part on the comparison, providing an indication if heat exchanger clogging is detected, as shown in step 240, or any combination thereof. In at least one example, determining expected operational parameters can include operating the cooling system 100 in steady state and/or at predetermined capacity and recording then current operational parameters as the expected operational parameters, as shown in step 250, and/or calculating the expected operational parameters, as shown in step 260. In at least one example, comparing the expected operational parameters with the current operational parameters can include calculating a difference between the expected operational parameters and the current operational parameters.

In at least one example, when recording current operational parameters as the expected operational parameters, as shown in step 250, the cooling system 100 and/or the cooling unit 110 can be allowed to operate without interference and operational parameters can be recorded. In at least one example, once enough data has been obtained for an operation range (which could be obtained for example by orthogonal space discretization), the current operation can be evaluated and/or compared to the cooling system's 100 and/or the cooling unit's 110 past operation. In at least one example, if the current operation and the past operation (i.e., the current operational parameters and the expected operational parameters) are similar (equal and/or within a threshold) the cooling system 100 can continue to operate without any changes or warnings. In at least one example, if there is a difference, an alarm or other message can be provided to report possible clogging. In at least one example, the method 200 can be implemented entirely or partially by the controller 120, which can be a local controller and/or part of a remote supervisory system. In at least one example, the method 200 can include following the cooling system's 100 and/or each cooling unit's 110 evolution over time and/or can address each unit 110 individually. In at least one example, once sufficient amount of data is collected, which may serve for wider generalization, the thresholds can be automatically updated by a unit type, configuration, coolant, etc.

In at least one example, the method 200 can include detecting clogging without historical data. In at least one example, the method 200 can include constructing and/or utilizing a mathematical model of the cooling system 100 and/or the cooling unit 110. In at least one example, the mathematical model can be as simple as calculating the energy consumption of a pump or compressor 150 and/or its capacity as a function of speed (such as in RPM), suction pressure, condensing pressure, or any combination thereof. In at least one example, the mathematical model can be or include different modelling techniques, such as white box modelling, gray box modelling, black box modelling, or any combination thereof. In at least one example, the method 200 can include constructing and/or utilizing different mathematical models for different cooling units 110 of the cooling system 100.

In at least one example, calculating the expected operational parameters can be based on one or more speeds, such as one or more fan speeds, one or more pump speeds, or any combination thereof. In at least one example, calculating the expected operational parameters can be based on one or more flow rates. In at least one example, calculating the expected operational parameters can be based on one or more pressures, such as one or more suction pressures, one or more discharge pressures, one or more condensing pressures, one or more differential pressures (such as across a heat exchanger and/or a filter), or any combination thereof. In at least one example, a method 200 for detecting heat exchanger clogging according to the disclosure can include utilizing one or more pressures and/or one or more pressure differential readings across the condenser 140 and/or a filter 190 serving the condenser 140, such as by utilizing the sensors 190 shown in FIG. 12 and/or FIG. 13. In at least one example, the sensors 180 can operate as differential pressure sensors and/or be utilized to check the pressure across the filter 190, the condenser 140 without the filter 190 or the condenser 140 with the filter 190. The pressure reading could be compared to the cooling capacity of the unit 110 and to the valve opening/pump speed data.

In at least one example, calculating the expected operational parameters can be based on one or more temperatures, such as one or more cooling medium temperatures, one or more refrigerant temperatures, one or more air temperatures, or any combination thereof. In at least one example, calculating the expected operational parameters can be based on one or more demand signals. In at least one example, calculating the expected operational parameters can be based on one or more capacities, such as one or more pump capacities, one or more compressor capacities, one or more plumbing capacities, one or more cooling capacities (such as of one or more cooling loops, circuits, or units), or any combination thereof.

In at least one example, calculating the expected operational parameters can include calculating one or more speeds, such as one or more fan speeds, one or more pump speeds, or any combination thereof. In at least one example, calculating the expected operational parameters can include calculating one or more flow rates. In at least one example, calculating the expected operational parameters can include calculating one or more pressures, such as one or more suction pressures, one or more discharge pressures, one or more condensing pressures, one or more differential pressures (such as across a heat exchanger and/or a filter), or any combination thereof. In at least one example, calculating the expected operational parameters can include calculating one or more temperatures, such as one or more cooling medium temperatures, one or more refrigerant temperatures, one or more air temperatures, or any combination thereof.

In at least one example, calculating the expected operational parameters can include calculating one or more speeds based on one or more capacities and/or one or more temperatures. In at least one example, calculating the expected operational parameters can include calculating one or more temperatures based on one or more capacities and/or one or more speeds. In at least one example, calculating the expected operational parameters can include calculating one or more capacities based on one or more speeds and/or one or more temperatures. In at least one example, calculating the expected operational parameters can include calculating one or more speeds based on one or more pressures and/or one or more temperatures. In at least one example, calculating the expected operational parameters can include calculating one or more temperatures based on one or more pressures and/or one or more speeds. In at least one example, calculating the expected operational parameters can include calculating one or more pressures based on one or more speeds and/or one or more temperatures.

In at least one example, the method 200 can include confirming that the cooling system 100 and/or the cooling unit 110 is running in steady state operation, and subsequently calculate the delivered cooling capacity. In at least one example, the method 200 can include calculating the expected pump speed or valve opening to deliver the necessary cooling for the condenser 140, such as based on the cooling capacity and the medium temperature and knowing the geometrical specifics of the condenser 140. In at least one example, the method 200 can include letting the cooling system 100 and/or the cooling unit 110 continue to run, if the actual operation is within an expected range. In at least one example, the method 200 can include providing an alarm, providing a warning, or providing a message, such as based on the size of the difference.

In at least one example, providing an indication if heat exchanger clogging is detected can include providing a warning, an alarm, or other message if clogging is detected. In at least one example, providing an indication if heat exchanger clogging is detected can include providing a message if the difference (between current and expected operational parameters) exceeds a first threshold. In at least one example, providing an indication if heat exchanger clogging is detected can include providing a warning if the difference exceeds a second threshold. In at least one example, providing an indication if heat exchanger clogging is detected can include providing an alarm if the difference exceeds a third threshold. In at least one example, the second threshold can be greater than the first threshold. In at least one example, the third threshold can be greater than the first threshold and/or the second threshold. In at least one example, a message can be advisory in nature and not trigger corrective action. In at least one example, a warning can trigger basic corrective action. In at least one example, a warning can trigger corrective action, that can be more urgent, more complex, more thorough, or any combination thereof.

In at least one example, a method 200 for detecting heat exchanger clogging in a cooling system 100 having a plurality of cooling units 110 according to the disclosure can include operating a first cooling unit 100 of the cooling system 100 at a predetermined capacity, detecting a first set of current operational parameters of the first cooling unit 110, recording the first set of current operational parameters of the first cooling unit 110 as expected operational parameters, determining a current capacity of the cooling system 100, calculating a maximum capacity of the cooling system 100 without the first cooling unit 110, waiting a predetermined period of time, performing a checking procedure 270 if the maximum capacity is greater than the current capacity, or any combination thereof. In at least one example, the checking procedure 270 can include operating the first cooling unit 110 at the predetermined capacity while providing the current capacity with the cooling system 100 (as a whole), detecting a second set of current operational parameters of the first cooling unit 110, comparing the expected operational parameters with the second set of current operational parameters, identifying heat exchanger clogging based at least in part on the comparison, or any combination thereof.

In at least one example, a method 200 for detecting heat exchanger clogging in a cooling system 100 having a plurality of cooling units 110 according to the disclosure can include forcing one or more cooling units 110 to operate with certain specified cooling capacity, which can be referred to as a reference condition. In at least one example, the reference condition and/or associated data can be obtained during unit startup or after cleaning, such as by forcing one or more cooling units 110 to operate at steady state and recording data about capacity, pump, speed valve opening, etc. In at least one example, a checking procedure 270 can include excluding one or more cooling units 110 from the cooling system 100 of units 110 if the total cooling capacity currently being provided is lower than the maximum cooling capacity of the remaining units 110 of the system 100. In at least one example, a checking procedure 270 can include operating the chosen unit 110 at the previously specified cooling capacity (i.e., the reference condition), waiting for the chosen unit 110 to achieve steady state, measuring current data of the chosen unit 110 (capacity, pump, speed valve opening, etc.), comparing those measurements with the previously recorded data (at the reference condition), providing an alarm, warning, or message based on the size of and difference the between the measurements and the previously recorded data (at the reference condition), or any combination thereof. In at least one example, after the checking procedure 270 has been performed, the chosen unit 110 can be reintroduced to the system 100 of units 110 (working in teamwork mode) and will continue in its normal cooling delivery operation as part of the system 100 (i.e., teamwork).

In at least one example, the current capacity can vary, such as according to a demand and/or a demand signal. In at least one example, the current capacity, as used herein, need not be a measure of maximum capability of the cooling system 100 or any component thereof. In at least one example, the current capacity, as used herein, can be a measure of a current cooling output of the cooling system 100, which can vary according to the demand and/or the demand signal. In at least one example, as the demand and/or the demand signal changes, the current capacity of the cooling system 100 can change to meet that demand and/or demand signal. In at least one example, as the demand and/or the demand signal changes, the current capacity of the cooling system 100 can change proportionally.

In at least one example, operating the first cooling unit 110 at the predetermined capacity while providing the current capacity with the cooling system 100 can include operating the first cooling unit 110 in steady state at the predetermined capacity and varying a second capacity of a second cooling unit 110 of the cooling system 100 in proportion to the demand and/or the demand signal. In at least one example, operating the first cooling unit 110 at the predetermined capacity while providing the current capacity with the cooling system 100 can include operating the first cooling unit 110 in steady state at the predetermined capacity and varying one or more other cooling units 110 of the cooling system 100 in proportion to the demand and/or the demand signal, such varying as one or more speeds, one or more flow rates, one or more outputs, one or more capacities, or any combination thereof of one or more other cooling units 110.

In at least one example, the checking procedure 270 can be performed periodically, such as daily, weekly, monthly, or any combination thereof. In at least one example, the checking procedure 270 can be performed periodically if the maximum capacity is greater than the current capacity. In at least one example, the checking procedure 270 can be performed periodically if, and only if, the maximum capacity is greater than the current capacity. In at least one example, the checking procedure 270 can be performed after a period of time has expired. In at least one example, the checking procedure 270 can be performed when the maximum capacity is greater than the current capacity after a period of time has expired. In at least one example, the checking procedure 270 can be performed after a period of time has expired and the current capacity drops below the maximum capacity.

In at least one example, the maximum capacity, as used herein, need not be the maximum capacity of the entire cooling system 100. In at least one example, the maximum capacity, as used herein, can be the maximum capacity of the cooling system 100 without one or more cooling units 110 of the cooling system 100. For example, if the cooling system 100 includes three cooling units, the maximum capacity, as used herein, can be the maximum capacity of two of the three cooling units 110 of the cooling system 100.

In at least one example, a method 200 for detecting heat exchanger clogging according to the disclosure can include utilizing two or more detection techniques. In at least one example, each of the above-described techniques could yield a different level of confidence of whether the condenser 140 is clogged or not. In at least one example, a method 200 can include providing a weighted sum of two or more of the above-described techniques. In at least one example, each technique can have an assigned weight "w", which can be based on each technique's sensitivity and/or precision. In at least one example, the sum of the weights can add up to 1:

$$\sum_{i=1}^{n} w_i = 1$$

In at least one example, the output of the above-described techniques can be a binary, such that if the given technique detected a presence of clogging, it's output can be 1, otherwise 0. In at least one example, the total detection confidence can be defined as follows:

$$\sum_{i=1}^{n} w_i n_i \geq confidence\ threshold$$

As a numerical example, with 3 evaluation techniques (there can be more or fewer techniques) and their weights being equal (one or more techniques can have higher weight than others), so the weights for values are 0.33, different levels of detection confidence can be defined as:

$$\sum_{i=1}^{n} w_i n_i \leq 0.33$$

Here, where only one of the techniques provided positive detection, the method 200 can include continuing to check the system 100 without providing an alarm or other message.

$$0.33 < \sum_{i=1}^{n} w_i n_i \leq 0.67$$

Here, where two of the techniques provided positive detection, the method 200 can include providing a warning or other message, which can trigger corrective action.

$$0.67 < \sum_{i=1}^{n} w_i n_i$$

Here, where three of the techniques provided positive detection, the method 200 can include providing an alarm and/or triggering more urgent and/or thorough corrective action.

In at least one example, a method 200 for detecting heat exchanger clogging according to the disclosure can include operating a cooling system 100 in steady state and recording a first set of current operational parameters of the cooling system 100 as a first set of expected operational parameters, determining a current capacity of the cooling system 100, calculating a second set of expected operational parameters based at least in part on the current capacity, detecting a second set of current operational parameters of the cooling system 100, comparing the second set of current operational parameters with the first set of expected operational parameters and the second set of expected operational parameters, identifying heat exchanger clogging based at least in part on the comparison, or any combination thereof. In at least one example, the first set of expected operational parameters can include an indication of a first capacity at which the first set of current operational parameters was recorded. In at least one example, the method 200 can include creating a first extrapolated set of expected operational parameters, such as by extrapolating the first set of expected operational parameters based at least in part on a difference between the current capacity and the first capacity. In at least one example, comparing the second set of current operational parameters with the first set of expected operational parameters can be or include comparing the second set of current operational parameters with the first extrapolated set of expected operational parameters. In at least one example, each set of current and/or expected operational parameters can include one or more expected operational parameters, such as one or more speeds, one or more flow rates, one or more pressures, one or more temperatures, one or more capacities, or any combination thereof.

In at least one example, identifying heat exchanger clogging based at least in part on the comparison can include determining that the second set of current operational parameters exceeds one or more of the expected operational parameters. In at least one example, identifying heat exchanger clogging based at least in part on the comparison can include determining that the second set of current operational parameters exceeds the first extrapolated set of expected operational parameters by a first threshold, determining that the second set of current operational parameters exceeds the second set of expected operational parameters by a second threshold, determining that the second set of current operational parameters exceeds the first extrapolated set of expected operational parameters by the first threshold and/or that the second set of current operational parameters exceeds the second set of expected operational parameters by the second threshold, or any combination thereof. In at least one example, the first threshold can be the same as, or different from, the second threshold.

In at least one example, identifying heat exchanger clogging based at least in part on the comparison can include determining that the second set of current operational parameters exceeds one or more of the sets of expected operational parameters by one or more thresholds. In at least one example, identifying heat exchanger clogging based at least in part on the comparison can include determining that the second set of current operational parameters exceeds either of the sets of expected operational parameters by one threshold or multiple sets of expected operational parameters by another threshold. In at least one example, identifying heat exchanger clogging based at least in part on the comparison can include weighting one or more set of expected operational parameters higher than another set of expected operational parameters. In at least one example, the method for detecting heat exchanger clogging according to the disclosure can provide an indication of heat exchanger clogging, in indication of a severity of heat exchanger clogging, an indication of a confidence level of heat exchanger clogging, or any combination thereof.

In at least one example, identifying heat exchanger clogging based at least in part on the comparison can include determining that the second set of current operational parameters exceeds the first extrapolated set of expected operational parameters and the second set of expected operational parameters by a first threshold, that the second set of current operational parameters exceeds the first extrapolated set of expected operational parameters by a second threshold, that the second set of current operational parameters exceeds the second set of expected operational parameters by a third threshold, or any combination thereof. In at least one example, the second threshold can be greater than the first threshold. In at least one example, the third threshold can be greater than the second threshold and/or the first threshold.

In at least one example, the method 200 can include operating a first cooling unit 110 of the cooling system 100 at a predetermined capacity, detecting a third set of current operational parameters of the first cooling unit 110, recording the third set of current operational parameters of the first cooling unit 110 as a third set of expected operational parameters, calculating a maximum capacity of the cooling system 100 without the first cooling unit 110, waiting a predetermined period of time, performing a checking procedure 270 if (and only if) the maximum capacity is greater than the current capacity, or any combination thereof. In at least one example, the checking procedure 270 can include operating the first cooling unit 110 at the predetermined capacity while providing the current capacity with the cooling system 100, detecting a fourth set of current operational parameters of the first cooling unit 110, or any combination thereof. In at least one example, comparing the current operational parameters with the expected operational parameters can include comparing the third set of expected operational parameters with the fourth set of current operational parameters.

In at least one example, identifying heat exchanger clogging based at least in part on the comparison can include determining that the second set of current operational parameters exceeds the first extrapolated set of expected operational parameters by a first threshold, the second set of current operational parameters exceeds the second set of expected operational parameters by a second threshold, and the fourth set of current operational parameters exceeds the third set of expected operational parameters by a third threshold. In at least one example, identifying heat exchanger clogging based at least in part on the comparison can include determining that the second set of current operational parameters exceeds the first extrapolated set of expected operational parameters by a first threshold and the second set of current operational parameters exceeds the second set of expected operational parameters by a second threshold, that the second set of current operational parameters exceeds the first extrapolated set of expected operational parameters by the first threshold and the fourth set of current operational parameters exceeds the third set of expected operational parameters by a third threshold, that the second set of current operational parameters exceeds the second set of expected operational parameters by the second threshold and the fourth set of current operational parameters exceeds the third set of expected operational parameters by the third threshold, or any combination thereof. In at least one example, the second threshold can be less than, greater than, or the same as the first threshold. In at least one example, the third threshold can be less than, greater than, or the same as the second threshold and/or the first threshold.

**As** will be appreciated by those skilled in the art having the benefits of the present disclosure, aspects of one or more examples of the disclosure can be embodied as a system, method or computer program product. Accordingly, aspects of the present examples can take the form of an entirely hardware example, an entirely software example (including firmware, resident software, micro-code, etc.) or an example combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to examples of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one example, a method for detecting heat exchanger clogging in a cooling system according to the disclosure can include determining expected operational parameters, detecting current operational parameters, confirming that the cooling system is operating in steady state as a prerequisite to detecting the current operational parameters, comparing the expected operational parameters with the current operational parameters, identifying heat exchanger clogging based at least in part on the comparison, providing an indication if heat exchanger clogging is detected, or any combination thereof. In at least one example, determining expected operational parameters can include operating the cooling system in steady state and/or at predetermined capacity and recording then current operational parameters as the expected operational parameters and/or calculating the expected operational parameters. In at least one example, comparing the expected operational parameters with the current operational parameters can include calculating a difference between the expected operational parameters and the current operational parameters.

In at least one example, calculating the expected operational parameters can be based on one or more speeds, such as one or more fan speeds, one or more pump speeds, or any combination thereof. In at least one example, calculating the expected operational parameters can be based on one or more flow rates. In at least one example, calculating the expected operational parameters can be based on one or more pressures, such as one or more suction pressures, one or more discharge pressures, one or more condensing pressures, one or more differential pressures (such as across a heat exchanger and/or a filter), or any combination thereof. In at least one example, calculating the expected operational parameters can be based on one or more temperatures, such as one or more cooling medium temperatures, one or more refrigerant temperatures, one or more air temperatures, or any combination thereof. In at least one example, calculating the expected operational parameters can be based on one or more demand signals. In at least one example, calculating the expected operational parameters can be based on one or more capacities, such as one or more pump capacities, one or more compressor capacities, one or more plumbing capacities, one or more cooling capacities (such as of one or more cooling loops, circuits, or units), or any combination thereof.

In at least one example, calculating the expected operational parameters can include calculating one or more speeds, such as one or more fan speeds, one or more pump speeds, or any combination thereof. In at least one example, calculating the expected operational parameters can include calculating one or more flow rates. In at least one example, calculating the expected operational parameters can include calculating one or more pressures, such as one or more suction pressures, one or more discharge pressures, one or more condensing pressures, one or more differential pressures (such as across a heat exchanger and/or a filter), or any combination thereof. In at least one example, calculating the expected operational parameters can include calculating one or more temperatures, such as one or more cooling medium temperatures, one or more refrigerant temperatures, one or more air temperatures, or any combination thereof.

In at least one example, providing an indication if heat exchanger clogging is detected can include providing a warning, an alarm, or other message if clogging is detected. In at least one example, providing an indication if heat exchanger clogging is detected can include providing a message if the difference (between current and expected operational parameters) exceeds a first threshold. In at least one example, providing an indication if heat exchanger clogging is detected can include providing a warning if the difference exceeds a second threshold. In at least one example, providing an indication if heat exchanger clogging is detected can include providing an alarm if the difference exceeds a third threshold. In at least one example, the second threshold can be greater than the first threshold. In at least one example, the third threshold can be greater than the first threshold and/or the second threshold.

In at least one example, a method for detecting heat exchanger clogging in a cooling system having a plurality of cooling units according to the disclosure can include operating a first cooling unit of the cooling system at a predetermined capacity, detecting a first set of current operational parameters of the first cooling unit, recording the first set of current operational parameters of the first cooling unit as expected operational parameters, determining a current capacity of the cooling system, calculating a maximum capacity of the cooling system without the first cooling unit, waiting a predetermined period of time, performing a checking procedure if the maximum capacity is greater than the current capacity, or any combination thereof. In at least one example, the checking procedure can include operating the first cooling unit at the predetermined capacity while providing the current capacity with the cooling system (as a whole), detecting a second set of current operational parameters of the first cooling unit, comparing the expected operational parameters with the second set of current operational parameters, identifying heat exchanger clogging based at least in part on the comparison, or any combination thereof.

In at least one example, the current capacity can vary, such as according to a demand and/or a demand signal. In at least one example, the current capacity, as used herein, need not be a measure of maximum capability. In at least one example, the current capacity, as used herein, can be a measure of a current cooling output of the cooling system, which can vary according to the demand and/or the demand signal. In at least one example, as the demand and/or the demand signal changes, the current capacity of the cooling system can change to meet that demand and/or demand signal. In at least one example, as the demand and/or the demand signal changes, the current capacity of the cooling system can change proportionally.

In at least one example, operating the first cooling unit at the predetermined capacity while providing the current capacity with the cooling system can include operating the first cooling unit in steady state at the predetermined capacity and varying a second capacity of a second cooling unit of the cooling system in proportion to the demand and/or the demand signal. In at least one example, operating the first cooling unit at the predetermined capacity while providing the current capacity with the cooling system can include operating the first cooling unit in steady state at the predetermined capacity and varying one or more other cooling units of the cooling system in proportion to the demand and/or the demand signal, such as one or more speeds, one or more flow rates, one or more outputs, one or more capacities, or any combination thereof of one or more other cooling units.

In at least one example, the checking procedure can be performed periodically, such as daily, weekly, monthly, or any combination thereof. In at least one example, the checking procedure can be performed periodically if the maximum capacity is greater than the current capacity. In at least one example, the checking procedure can be performed periodically if, and only if, the maximum capacity is greater than the current capacity. In at least one example, the checking procedure can be performed after a period of time has expired. In at least one example, the checking procedure can be performed when the maximum capacity is greater than the current capacity after a period of time has expired. In at least one example, the checking procedure can be performed after a period of time has expired and the current capacity drops below the maximum capacity.

In at least one example, the maximum capacity, as used herein, need not be the maximum capacity of the entire cooling system. In at least one example, the maximum capacity, as used herein, can be the maximum capacity of the cooling system without one or more cooling units of the cooling system.

In at least one example, a method for detecting heat exchanger clogging according to the disclosure can include utilizing two or more detection techniques. In at least one example, a method for detecting heat exchanger clogging according to the disclosure can include operating a cooling system in steady state and recording a first set of current operational parameters of the cooling system as a first set of expected operational parameters, determining a current capacity of the cooling system, calculating a second set of expected operational parameters based at least in part on the current capacity, detecting a second set of current operational parameters of the cooling system, comparing the second set of current operational parameters with the first set of expected operational parameters and the second set of expected operational parameters, identifying heat exchanger clogging based at least in part on the comparison, or any combination thereof. In at least one example, the first set of expected operational parameters can include an indication of a first capacity at which the first set of current operational parameters was recorded. In at least one example, the method can include creating a first extrapolated set of expected operational parameters, such as by extrapolating the first set of expected operational parameters based at least in part on a difference between the current capacity and the first capacity. In at least one example, comparing the second set of current operational parameters with the first set of expected operational parameters can be or include comparing the second set of current operational parameters with the first extrapolated set of expected operational parameters. In at least one example, each set of current and/or expected operational parameters can include one or more expected operational parameters, such as one or more speeds, one or more flow rates, one or more pressures, one or more temperatures, one or more capacities, or any combination thereof.

In at least one example, identifying heat exchanger clogging based at least in part on the comparison can include determining that the second set of current operational parameters exceeds one or more of the expected operational parameters. In at least one example, identifying heat exchanger clogging based at least in part on the comparison can include determining that the second set of current operational parameters exceeds the first extrapolated set of expected operational parameters by a first threshold, determining that the second set of current operational parameters exceeds the second set of expected operational parameters by a second threshold, determining that the second set of current operational parameters exceeds the first extrapolated set of expected operational parameters by the first threshold and/or that the second set of current operational parameters exceeds the second set of expected operational parameters by the second threshold, or any combination thereof. In at least one example, the first threshold can be the same as, or different from, the second threshold.

In at least one example, identifying heat exchanger clogging based at least in part on the comparison can include determining that the second set of current operational parameters exceeds one or more of the sets of expected operational parameters by one or more thresholds. In at least one example, identifying heat exchanger clogging based at least in part on the comparison can include determining that the second set of current operational parameters exceeds either of the sets of expected operational parameters by one threshold or multiple sets of expected operational parameters by another threshold. In at least one example, identifying heat exchanger clogging based at least in part on the comparison can include weighting one or more set of expected operational parameters higher than another set of expected operational parameters. In at least one example, the method for detecting heat exchanger clogging according to the disclosure can provide an indication of heat exchanger clogging, in indication of a severity of heat exchanger clogging, an indication of a confidence level of heat exchanger clogging, or any combination thereof.

In at least one example, identifying heat exchanger clogging based at least in part on the comparison can include determining that the second set of current operational parameters exceeds the first extrapolated set of expected operational parameters and the second set of expected operational parameters by a first threshold, that the second set of current operational parameters exceeds the first extrapolated set of expected operational parameters by a second threshold, that the second set of current operational parameters exceeds the second set of expected operational parameters by a third threshold, or any combination thereof. In at least one example, the second threshold can be greater than the first threshold. In at least one example, the third threshold can be greater than the second threshold and/or the first threshold.

In at least one example, the method can include operating a first cooling unit of the cooling system at a predetermined capacity, detecting a third set of current operational parameters of the first cooling unit, recording the third set of current operational parameters of the first cooling unit as a third set of expected operational parameters, calculating a maximum capacity of the cooling system without the first cooling unit, waiting a predetermined period of time, performing a checking procedure if (and only if) the maximum capacity is greater than the current capacity, or any combination thereof. In at least one example, the checking procedure can include operating the first cooling unit at the predetermined capacity while providing the current capacity with the cooling system, detecting a fourth set of current operational parameters of the first cooling unit, or any combination thereof. In at least one example, comparing the current operational parameters with the expected operational parameters can include comparing the third set of expected operational parameters with the fourth set of current operational parameters.

In at least one example, identifying heat exchanger clogging based at least in part on the comparison can include determining that the second set of current operational parameters exceeds the first extrapolated set of expected operational parameters by a first threshold, the second set of current operational parameters exceeds the second set of expected operational parameters by a second threshold, and the fourth set of current operational parameters exceeds the third set of expected operational parameters by a third threshold. In at least one example, identifying heat exchanger clogging based at least in part on the comparison can include determining that the second set of current operational parameters exceeds the first extrapolated set of expected operational parameters by a first threshold and the second set of current operational parameters exceeds the second set of expected operational parameters by a second threshold, that the second set of current operational parameters exceeds the first extrapolated set of expected operational parameters by the first threshold and the fourth set of current operational parameters exceeds the third set of expected operational parameters by a third threshold, that the second set of current operational parameters exceeds the second set of expected operational parameters by the second threshold and the fourth set of current operational parameters exceeds the third set of expected operational parameters by the third threshold, or any combination thereof. In at least one example, the second threshold can be less than, greater than, or the same as the first threshold. In at least one example, the third threshold can be less than, greater than, or the same as the second threshold and/or the first threshold.

example The various methods and examples of the devices, systems and methods can be included in combination with each other to produce variations of the disclosed methods and examples. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The inventions have been described in the context of preferred and other examples and not every example of the inventions has been described. Obvious modifications and alterations to the described examples are available to those of ordinary skill in the art having the benefits of the present disclosure. The disclosed and undisclosed examples are not intended to limit or restrict the scope or applicability of the inventions conceived of by the Applicant, but rather, in conformity with the patent laws, Applicant intends to fully protect all such modifications and improvements that come within the scope or range of equivalents of the following claims.

Described herein are also the following clauses:

1. A method for detecting heat exchanger clogging, the method comprising: determining expected operational parameters of a cooling system; detecting current operational parameters of the cooling system based at least in part on a signal from one or more sensors disposed in sensing communication with the cooling system; comparing the expected operational parameters with the current operational parameters; and identifying heat exchanger clogging based at least in part on the comparing.

2. The method as set forth in clause 1, wherein the determining comprises operating the cooling system in steady state and recording then current operational parameters as the expected operational parameters.

3. The method as set forth in clause 1, wherein the determining comprises calculating the expected operational parameters.

4. The method as set forth in clause 3, wherein the calculating is based at least in part on a speed, a pressure, and a temperature.

5. The method as set forth in clause 3, wherein the calculating is based at least in part on a cooling medium temperature.

6. The method as set forth in clause 3, wherein the calculating is based at least in part on a demand signal.

7. The method as set forth in clause 3, wherein the calculating comprises calculating at least one of an expected speed and an expected valve position.

8. The method as set forth in clause 1, wherein the determining comprises operating the cooling system at a predetermined capacity and recording then current operational parameters as the expected operational parameters.

9. The method as set forth in clause 1, further comprising confirming that the cooling system is operating in steady state as a prerequisite to detecting the current operational parameters.

10. The method as set forth in clause 1, wherein the comparing comprises calculating a difference between the expected operational parameters and the current operational parameters.

11. The method as set forth in clause 10, further comprising providing a message if the difference exceeds a first threshold, providing a warning if the difference exceeds a second threshold, and providing an alarm if the difference exceeds a third threshold; wherein the second threshold is greater than the first threshold; wherein the third threshold is greater than the second threshold; wherein the message is different than the warning; and wherein the alarm is different than the message and the warning.

12. A method for detecting heat exchanger clogging in a cooling system having a plurality of cooling units, the method comprising: operating a first cooling unit of the cooling system at a predetermined capacity; detecting a first set of current operational parameters of the first cooling unit; recording the first set of current operational parameters of the first cooling unit as expected operational parameters; determining a current capacity of the cooling system; calculating a maximum capacity of the cooling system without the first cooling unit; and performing a checking procedure if the maximum capacity is greater than the current capacity; wherein the checking procedure comprises operating the first cooling unit at the predetermined capacity while providing the current capacity with the cooling system; detecting a second set of current operational parameters of the first cooling unit; comparing the expected operational parameters with the second set of current operational parameters; and identifying heat exchanger clogging based at least in part on the comparing.

13. The method as set forth in clause 12, wherein the current capacity varies according to a demand signal.

14. The method as set forth in clause 13, wherein operating the first cooling unit at the predetermined capacity while providing the current capacity with the cooling system comprises operating the first cooling unit in steady state at the predetermined capacity and varying a second capacity of a second cooling unit of the cooling system in proportion to the demand signal.

15. The method as set forth in clause 12, wherein the checking procedure is performed periodically if, and only if, the maximum capacity is greater than the current capacity.

16. The method as set forth in clause 12, wherein the checking procedure is performed when the maximum capacity is greater than the current capacity after a period of time has expired.

17. A method for detecting heat exchanger clogging, the method comprising:

operating a cooling system in steady state and recording a first set of current operational parameters of the cooling system as a first set of expected operational parameters, wherein the first set of expected operational parameters includes an indication of a first capacity at which the first set of current operational parameters was recorded; determining a current capacity of the cooling system; calculating a second set of expected operational parameters based at least in part on the current capacity; creating a first extrapolated set of expected operational parameters by extrapolating the first set of expected operational parameters based at least in part on a difference between the current capacity and the first capacity; detecting a second set of current operational parameters of the cooling system; comparing the second set of current operational parameters with the first extrapolated set of expected operational parameters and the second set of expected operational parameters; and identifying heat exchanger clogging based at least in part on the comparing.

18. The method as set forth in clause 17, wherein the identifying comprises determining either that the second set of current operational parameters exceeds the first extrapolated set of expected operational parameters by a first threshold or that the second set of current operational parameters exceeds the second set of expected operational parameters by a second threshold.

19. The method as set forth in clause 17, wherein the identifying comprises determining that the second set of current operational parameters exceeds the first extrapolated set of expected operational parameters by a first threshold and that the second set of current operational parameters exceeds the second set of expected operational parameters by a second threshold.

20. The method as set forth in clause 17, wherein the identifying comprises determining either that the second set of current operational parameters exceeds the first extrapolated set of expected operational parameters and the second set of expected operational parameters by a first threshold, that the second set of current operational parameters exceeds the first extrapolated set of expected operational parameters by a second threshold, or that he second set of current operational parameters exceeds the second set of expected operational parameters by a third threshold, wherein the second threshold is greater than the first threshold and the third threshold is greater than the first threshold.

Described herein are also the following items:

1. A method for detecting heat exchanger clogging, the method comprising:

determining expected operational parameters of a cooling system;
detecting current operational parameters of the cooling system based at least in part on a signal from one or more sensors disposed in sensing communication with the cooling system;
comparing the expected operational parameters with the current operational parameters; and
identifying heat exchanger clogging based at least in part on the comparing.

2. The method as set forth in item 1, wherein the determining comprises operating the cooling system in steady state and recording then current operational parameters as the expected operational parameters.

3. The method as set forth in any preceding item, wherein the determining comprises calculating the expected operational parameters; and optionally, wherein the calculating is based at least in part on a speed, a pressure, and a temperature; and optionally, wherein the calculating is based at least in part on a cooling medium temperature; and optionally, wherein the calculating is based at least in part on a demand signal; and optionally, wherein the calculating comprises calculating at least one of an expected speed and an expected valve position.

4. The method as set forth in item 1, wherein the determining comprises operating the cooling system at a predetermined capacity and recording then current operational parameters as the expected operational parameters.

5. The method as set forth in any preceding item, further comprising confirming that the cooling system is operating in steady state as a prerequisite to detecting the current operational parameters.

6. The method as set forth in any preceding item, wherein the comparing comprises calculating a difference between the expected operational parameters and the current operational parameters.

7. The method as set forth in item 6, further comprising providing a message if the difference exceeds a first threshold, providing a warning if the difference exceeds a second threshold, and providing an alarm if the difference exceeds a third threshold; wherein the second threshold is greater than the first threshold; wherein the third threshold is greater than the second threshold; wherein the message is different than the warning; and wherein the alarm is different than the message and the warning.

8. A method of item 1, the method further comprising: operating the cooling system in steady state and recording a first set of current operational parameters of the cooling system as a first set of expected operational parameters, wherein the first set of expected operational parameters includes an indication of a first capacity at which the first set of current operational parameters was recorded; determining a current capacity of the cooling system; calculating a second set of expected operational parameters based at least in part on the current capacity; creating a first extrapolated set of expected operational parameters by extrapolating the first set of expected operational parameters based at least in part on a difference between the current capacity and the first capacity; detecting a second set of current operational parameters of the cooling system; wherein comparing the expected operational parameters with the current operational parameters comprises comparing the second set of current operational parameters with the first extrapolated set of expected operational parameters and the second set of expected operational parameters.

9. The method as set forth in item 8, wherein the identifying comprises determining either that the second set of current operational parameters exceeds the first extrapolated set of expected operational parameters by a first threshold or that the second set of current operational parameters exceeds the second set of expected operational parameters by a second threshold; and optionally, identifying comprises determining that the second set of current operational parameters exceeds the first extrapolated set of expected operational parameters by a first threshold and that the second set of current operational parameters exceeds the second set of expected operational parameters by a second threshold; and optionally, the identifying comprises determining either that the second set of current operational parameters exceeds the first extrapolated set of expected operational parameters and the second set of expected operational parameters by a first threshold, that the second set of current operational parameters exceeds the first extrapolated set of expected operational parameters by a second threshold, or that he second set of current operational parameters exceeds the second set of expected operational parameters by a third threshold, wherein the second threshold is greater than the first threshold and the third threshold is greater than the first threshold; and optionally, wherein the identifying comprises determining either that the second set of current operational parameters exceeds the first extrapolated set of expected operational parameters and the second set of expected operational parameters by a first threshold, that the second set of current operational parameters exceeds the first extrapolated set of expected operational parameters by a second threshold, or that he second set of current operational parameters exceeds the second set of expected operational parameters by a third threshold, wherein the second threshold is greater than the first threshold and the third threshold is greater than the first threshold.

10. A method of item 1, wherein the cooling system comprises a plurality of cooling units, the method comprising: operating a first cooling unit of the cooling system at a predetermined capacity; detecting a first set of current operational parameters of the first cooling unit;

recording the first set of current operational parameters of the first cooling unit as expected operational parameters; determining a current capacity of the cooling system; calculating a maximum capacity of the cooling system without the first cooling unit; and performing a checking procedure if the maximum capacity is greater than the current capacity; wherein the checking procedure comprises operating the first cooling unit at the predetermined capacity while providing the current capacity with the cooling system; detecting a second set of current operational parameters of the first cooling unit; wherein comparing the expected operational parameters with the current operational parameters comprises comparing the expected operational parameters with the second set of current operational parameters.

11. The method as set forth in item 10, wherein the current capacity varies according to a demand signal.

12. The method as set forth in any one of items 10 to 11, wherein operating the first cooling unit at the predetermined capacity while providing the current capacity with the cooling system comprises operating the first cooling unit in steady state at the predetermined capacity and varying a second capacity of a second cooling unit of the cooling system in proportion to the demand signal.

13. The method as set forth in any one of the items 10 to 12, wherein the checking procedure is performed periodically if, and only if, the maximum capacity is greater than the current capacity.

14. The method as set forth in any one of the items 10 to 12, wherein the checking procedure is performed when the maximum capacity is greater than the current capacity after a period of time has expired.

15. A system comprising:

one or more cooling units; and
one or more controllers configured to control the system according to the method in any preceding claim.

## Claims

1. A method for detecting heat exchanger clogging, the method comprising:

    determining expected operational parameters of a cooling system;
    detecting current operational parameters of the cooling system based at least in part on a signal from one or more sensors disposed in sensing communication with the cooling system;
    comparing the expected operational parameters with the current operational parameters; and
    identifying heat exchanger clogging based at least in part on the comparing.

2. The method as set forth in claim 1, wherein the determining comprises operating the cooling system in steady state and recording then current operational parameters as the expected operational parameters.

3. The method as set forth in any preceding claim, wherein the determining comprises calculating the expected operational parameters;

    and optionally, wherein the calculating is based at least in part on a speed, a pressure, and a temperature;
    and optionally, wherein the calculating is based at least in part on a cooling medium temperature;
    and optionally, wherein the calculating is based at least in part on a demand signal;
    and optionally, wherein the calculating comprises calculating at least one of an expected speed and an expected valve position.

4. The method as set forth in claim 1, wherein the determining comprises operating the cooling system at a predetermined capacity and recording then current operational parameters as the expected operational parameters.

5. The method as set forth in any preceding claim, further comprising confirming that the cooling system is operating in steady state as a prerequisite to detecting the current operational parameters.

6. The method as set forth in any preceding claim, wherein the comparing comprises calculating a difference between the expected operational parameters and the current operational parameters.

7. The method as set forth in claim 6, further comprising providing a message if the difference exceeds a first threshold, providing a warning if the difference exceeds a second threshold, and providing an alarm if the difference exceeds a third threshold; wherein the second threshold is greater than the first threshold; wherein the third threshold is greater than the second threshold; wherein the message is different than the warning; and wherein the alarm is different than the message and the warning.

8. A method of claim 1, the method further comprising:

operating the cooling system in steady state and recording a first set of current operational parameters of the cooling system as a first set of expected operational parameters, wherein the first set of expected operational parameters includes an indication of a first capacity at which the first set of current operational parameters was recorded;
determining a current capacity of the cooling system;
calculating a second set of expected operational parameters based at least in part on the current capacity;
creating a first extrapolated set of expected operational parameters by extrapolating the first set of expected operational parameters based at least in part on a difference between the current capacity and the first capacity;
detecting a second set of current operational parameters of the cooling system;
wherein comparing the expected operational parameters with the current operational parameters comprises comparing the second set of current operational parameters with the first extrapolated set of expected operational parameters and the second set of expected operational parameters.

9. The method as set forth in claim 8, wherein the identifying comprises determining either that the second set of current operational parameters exceeds the first extrapolated set of expected operational parameters by a first threshold or that the second set of current operational parameters exceeds the second set of expected operational parameters by a second threshold;

and optionally, identifying comprises determining that the second set of current operational parameters exceeds the first extrapolated set of expected operational parameters by a first threshold and that the second set of current operational parameters exceeds the second set of expected operational parameters by a second threshold;
and optionally, the identifying comprises determining either that the second set of current operational parameters exceeds the first extrapolated set of expected operational parameters and the second set of expected operational parameters by a first threshold, that the second set of current operational parameters exceeds the first extrapolated set of expected operational parameters by a second threshold, or that he second set of current operational parameters exceeds the second set of expected operational parameters by a third threshold, wherein the second threshold is greater than the first threshold and the third threshold is greater than the first threshold;
and optionally, wherein the identifying comprises determining either that the second set of current operational parameters exceeds the first extrapolated set of expected operational parameters and the second set of expected operational parameters by a first threshold, that the second set of current operational parameters exceeds the first extrapolated set of expected operational parameters by a second threshold, or that he second set of current operational parameters exceeds the second set of expected operational parameters by a third threshold, wherein the second threshold is greater than the first threshold and the third threshold is greater than the first threshold.

10. A method of claim 1, wherein the cooling system comprises a plurality of cooling units, the method comprising:

operating a first cooling unit of the cooling system at a predetermined capacity;
detecting a first set of current operational parameters of the first cooling unit;
recording the first set of current operational parameters of the first cooling unit as expected operational parameters;
determining a current capacity of the cooling system;
calculating a maximum capacity of the cooling system without the first cooling unit; and
performing a checking procedure if the maximum capacity is greater than the current capacity;
wherein the checking procedure comprises

operating the first cooling unit at the predetermined capacity while providing the current capacity with the cooling system;
detecting a second set of current operational parameters of the first cooling unit;
wherein comparing the expected operational parameters with the current operational parameters comprises comparing the expected operational parameters with the second set of current operational parameters.

11. The method as set forth in claim 10, wherein the current capacity varies according to a demand signal.

12. The method as set forth in any one of claims 10 to 11, wherein operating the first cooling unit at the predetermined capacity while providing the current capacity with the cooling system comprises operating the first cooling unit in steady state at the predetermined capacity and varying a second capacity of a second cooling unit of the cooling system in proportion to the demand signal.

13. The method as set forth in any one of the claims 10 to 12, wherein the checking procedure is performed periodically if, and only if, the maximum capacity is greater than the current capacity.

14. The method as set forth in any one of the claims 10 to 12, wherein the checking procedure is performed when the maximum capacity is greater than the current capacity after a period of time has expired.

15. A system comprising:

one or more cooling units; and
one or more controllers configured to control the system according to the method in any preceding claim.

FIG. 1

FIG. 2

**FIG. 3**

**FIG. 4**

Water Side (User or Source) | Refrigerant Side

**FIG. 5**

**FIG. 6**

**Single Unit Operation - History Based (Self Comparison)**

FIG. 7

**Single Unit Operation - Computation Based**

200

```
┌──────────────┐     ┌──────────────┐     ┌──────────────┐     ┌──────────────┐     ┌──────────────┐
│ Unit Working │     │  Calculate   │     │ Get Cooling  │     │  Calculate   │     │ Get Current  │
│   In Steady  │ ──> │   Cooling    │ ──> │    Medium    │ ──> │   Expected   │ ──> │  Pump Speed /│
│    State     │     │   Capacity   │     │ Temperature  │     │ Pump Speed / │     │Valve Opening │
│  Operation?  │     │              │     │              │     │Valve Opening │     │              │
└──────────────┘     └──────────────┘     └──────────────┘     └──────────────┘     └──────────────┘
      220                  260                  210                  260                  210
```

```
┌──────────────┐     ┌──────────────┐     ┌──────────────┐     ┌──────────────┐
│              │ No  │ If Current > │ No  │ If Current > │ No  │ If Current > │
│Everything is │<────│  Expected +  │<────│  Expected +  │<────│  Expected +  │
│     Ok       │     │  Threshold 1 │     │  Threshold 2 │     │  Threshold 3 │
└──────────────┘     └──────────────┘     └──────────────┘     └──────────────┘
                      230      │Yes        230      │Yes        230      │Yes
                               ▼                    ▼                    ▼
                      ┌──────────────┐     ┌──────────────┐     ┌──────────────┐
                      │ Raise Message│     │ Raise Warning│     │  Raise Alarm │
                      └──────────────┘     └──────────────┘     └──────────────┘
                            240                  240                  240
```

**FIG. 8**

EP 4 770 297 A1

**Utilizing N+1 Configuration**

FIG. 9

270

**Perform checking procedure**

FIG. 10

Shell and Tube

Hot Refrigerant

180

190

180

140

180

Cold Medium

Hot Medium

Cold Refrigerant

**FIG. 11**

EP 4 770 297 A1

Plate Exchanger

190

180

180

180

Cold Medium

140

Hot Medium

ColdRefrigerant

Hot Refrigerant

**FIG. 12**

# EP 4 770 297 A1

Europäisches
Patentamt
European
Patent Office
Office européen
des brevets

## EUROPEAN SEARCH REPORT

**Application Number**

EP 25 22 6830

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 057 517 B1 (FISHER ROSEMOUNT SYSTEMS INC [US]) 12 June 2013 (2013-06-12) | 1-7,15 | INV.<br>H05K7/20 |
| A | * paragraph [0018] - paragraph [0150]; figures 2,5,6,8,11,12,13 * | 8-14 | F28F27/00<br>G05B23/02<br>F24F11/64 |
| A | EP 3 434 983 B1 (SAMSON AG [DE]) 14 August 2019 (2019-08-14) * paragraph [0006] - paragraph [0030] * | 1-15 | |
| A | WO 2020/069629 A1 (S A ARMSTRONG LTD [CA]) 9 April 2020 (2020-04-09) * paragraph [00274] - paragraph [00328]; figures 7A,7B,7C * | 1-15 | |

**TECHNICAL FIELDS SEARCHED (IPC)**

G05B
F24F

The present search report has been drawn up for all claims

| Place of search | Date of completion of the search | Examiner |
|---|---|---|
| The Hague | 11 May 2026 | Rostan, Nicky |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 25 22 6830

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2026

| Patent document cited in search report | | Publication date | Patent family member(s) | | Publication date |
|---|---|---|---|---|---|
| EP  2057517 | B1 | 12-06-2013 | CN | 101535909 A | 16-09-2009 |
| | | | CN | 102789226 A | 21-11-2012 |
| | | | EP | 2057517 A2 | 13-05-2009 |
| | | | EP | 2392982 A2 | 07-12-2011 |
| | | | JP | 5197610 B2 | 15-05-2013 |
| | | | JP | 5650173 B2 | 07-01-2015 |
| | | | JP | 2010506268 A | 25-02-2010 |
| | | | JP | 2013008385 A | 10-01-2013 |
| | | | US | 2008082304 A1 | 03-04-2008 |
| | | | WO | 2008040018 A2 | 03-04-2008 |
| EP  3434983 | B1 | 14-08-2019 | CN | 109297733 A | 01-02-2019 |
| | | | DE | 102017116834 A1 | 31-01-2019 |
| | | | EP | 3434983 A1 | 30-01-2019 |
| | | | PL | 3434983 T3 | 28-02-2020 |
| WO 2020069629 | A1 | 09-04-2020 | BR | 112021006351 A2 | 06-07-2021 |
| | | | CA | 3062100 A1 | 13-02-2020 |
| | | | CA | 3110342 A1 | 13-02-2020 |
| | | | CA | 3110419 A1 | 13-02-2020 |
| | | | CA | 3169572 A1 | 13-02-2020 |
| | | | CA | 3187656 A1 | 13-02-2020 |
| | | | CN | 112805528 A | 14-05-2021 |
| | | | CN | 115790233 A | 14-03-2023 |
| | | | EP | 3861272 A1 | 11-08-2021 |
| | | | EP | 4184110 A1 | 24-05-2023 |
| | | | EP | 4357719 A2 | 24-04-2024 |
| | | | EP | 4382850 A2 | 12-06-2024 |
| | | | SG | 11202102259W A | 29-04-2021 |
| | | | US | 2021088264 A1 | 25-03-2021 |
| | | | US | 2023280076 A1 | 07-09-2023 |
| | | | US | 2025180265 A1 | 05-06-2025 |
| | | | WO | 2020069629 A1 | 09-04-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63739449

- US 42379525